# EUROPEAN PATENT APPLICATION

(11) **EP 4 489 300 A1**
(43) Date of publication of application: **08.01.2025**
(21) Application number: 24185998.2
(22) Date of filing: 02.07.2024
(51) Int. Cl.: H03F 1/02, H03F 1/32, H03F 3/195, H03F 3/24

(54) **SYMBOL BASED ENVELOPE TRACKING AND CREST FACTOR REDUCTION**

(30) Priority: 05.07.2023 US 202363512041 P
(71) Applicant: Analog Devices International Unlimited Company, Limerick (IE)
(72) Inventor: COPE, Mark, Limerick (IE); ZHANG, Yong, Limerick (IE); ARNOLD, Alexander Robert, Wilmington 01887 (US); BHAL, Shipra, Wilmington 01887 (US)
(74) Representative: Horler, Philip John

(57) **Abstract**

Aspects of this disclosure relate to symbol based envelope tracking. A voltage modulator circuit can generate an output bias voltage that tracks a root mean square symbol power of a radio frequency signal. A crest factor reduction circuit in a signal path that provides the radio frequency signal can adjust a crest factor reduction threshold such that the crest factor reduction threshold corresponds to the output bias voltage.

## Description

### CROSS REFERENCE TO PRIORITY APPLICATION

This application claims the benefit of priority of U.S. Provisional Application No. 63/512,041, filed July 5, 2023 and titled "SYMBOL BASED ENVELOPE TRACKING," the disclosure of which is hereby incorporated by reference in its entirety and for all purposes.

### BACKGROUND

### TECHNICAL FIELD

Embodiments of this disclosure relate to systems that generate a bias voltage for a power amplifier with symbol base envelope tracking.

### DESCRIPTION OF RELATED TECHNOLOGY

Radio systems can transmit and receive signals in the form of electromagnetic waves having a frequency in range from approximately 30 kilohertz (kHz) to 300 Gigahertz (GHz). Radio systems can be used for wireless communications, such as cellular communications and/or other wireless network communications.

Radio systems that transmit signals often include a power amplifier to amplify a radio frequency (RF) signal for transmission via one or more antennas. Power amplifiers can consume significant power in such systems. Power efficient power amplifiers can be desirable for a variety of applications.

### SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is a power amplifier system with symbol based envelope tracking that includes a voltage modulator circuit, a power amplifier and a signal path. The voltage modulator circuit is configured to generate an output bias voltage that tracks a root mean square symbol power of a radio frequency signal. The voltage modulator circuit is configured to adjust the output bias voltage on symbol boundaries. The power amplifier is configured to receive the output bias voltage and amplify the radio frequency signal. The signal path is configured to provide the radio frequency signal to the power amplifier. The signal path includes a crest factor reduction block configured to adjust a crest factor reduction threshold such that the crest factor reduction threshold corresponds to the output bias voltage.

The power amplifier system can include a quantizer configured to determine a symbol based envelope tracking state based on transmit signal power. The voltage modulator circuit can generate the output bias voltage based on the symbol based envelope tracking state. The crest factor reduction block can adjust the crest factor reduction threshold based on the symbol based envelope tracking state. The signal path can include a digital predistortion system coupled between the crest factor reduction block and a digital-to-analog converter. The digital predistortion system can adjust digital predistortion based on the symbol based envelope tracking state. The quantizer can receive a composite transmit symbol power associated with a plurality of carriers.

The signal path can include a digital-to-analog converter coupled between an output of the crest factor reduction block and an input to the power amplifier.

The power amplifier system can be operable in a discontinuous transmit state. A power amplifier transistor of the power amplifier system can have an output terminal connected to ground in the discontinuous transmit state. A power amplifier transistor of the power amplifier system can have an output terminal that is floating in the discontinuous transmit state.

The radio frequency signal can include at least two carriers with different symbol lengths. The voltage modulator circuit can adjust the output bias voltage corresponding to symbol boundaries of a carrier of the at least two carriers with a shortest symbol period.

The power amplifier can include a main power amplifier transistor coupled to the voltage modulator circuit and a peaking power amplifier transistor coupled to a fixed voltage supply. The power amplifier can include a main power amplifier transistor coupled to the voltage modulator circuit and a peaking power amplifier transistor coupled to the voltage modulator circuit. The power amplifier can include a main power amplifier transistor coupled to the voltage modulator circuit and a peaking power amplifier transistor coupled to a second voltage modulator circuit.

The voltage modulator circuit can transition the output bias voltage between discrete voltage levels in a time that is in a range between 5 nanoseconds and 200 nanoseconds.

The voltage modulator circuit can transition the output bias voltage between discrete voltage levels of at least 4 discrete voltage levels on the symbol boundaries.

A base station can include the power amplifier system.

Another aspect of this disclosure is a method of radio frequency signal amplification with symbol based envelope tracking. The method includes: determining a symbol based envelope tracking state based on transmit signal power; toggling an output bias voltage between a plurality of discrete voltage levels on symbol boundaries of a radio frequency signal based on the symbol based envelope tracking state, wherein the output bias voltage is provided to a power amplifier; adjusting a crest factor reduction threshold of a crest factor reduction block based on the symbol based envelope tracking state, the crest factor reduction block being in a signal path that provides the radio frequency signal to the power amplifier; and amplifying the radio frequency signal with the power amplifier.

The method can include adjusting digital predistortion in the signal path based on the symbol based envelope tracking state.

The method can include operating a power amplifier system that includes the power amplifier in a discontinuous transmit state.

The radio frequency signal can include two carriers having different symbol periods. Toggling the output voltage can occurs on symbol boundaries of a carrier of the two carriers with a shorter symbol period.

Another aspect of this disclosure is a system with symbol based envelope tracking. The system includes means for generating an output bias voltage that tracks a root mean square symbol power of a radio frequency signal on a symbol-by-symbol basis, and a signal path configured to provide the radio frequency signal. The signal path includes a crest factor reduction block configured to adjust a crest factor reduction threshold such that the crest factor reduction threshold corresponds to the output bias voltage.

Another aspect of this disclosure is a power amplifier system with symbol based envelope tracking that includes a voltage modulator circuit, a power amplifier, and a signal path configured to provide a radio frequency signal to the power amplifier. The voltage modulator circuit is configured to generate an output bias voltage based on a symbol based envelope tracking state such that the output bias voltage tracks a root mean square symbol power of the radio frequency signal on a symbol by symbol basis. The power amplifier is configured to receive the output bias voltage and amplify the radio frequency signal. The includes a digital predistortion system configured to adjust digital predistortion based on the symbol based envelope tracking state.

The digital predistortion system can adjust digital predistortion by at least adjusting digital predistortion coefficients. The digital predistortion system can adjust digital predistortion by at least adjusting a digital predistortion actuator.

The power amplifier system can include a quantizer configured to determine the symbol based envelope tracking state based on transmit signal power. The quantizer can receive a composite transmit symbol power associated with a plurality of carriers. The power amplifier system can include one or more delay blocks coupled between the quantizer and the digital predistortion system.

The signal path can include a crest factor reduction block configured to adjust a crest factor reduction threshold based on the symbol based envelope tracking state.

The power amplifier system can be operable in a discontinuous transmit state.

The radio frequency signal can include at least two carriers with different symbol lengths. The voltage modulator circuit can adjust the output bias voltage corresponding to symbol boundaries of a carrier of the at least two carriers with a shortest symbol period.

The voltage modulator circuit can transition the output bias voltage between discrete voltage levels of at least 4 discrete voltage levels on symbol boundaries.

The power amplifier can be a Doherty power amplifier.

Another aspect of this disclosure is a method of radio frequency signal amplification with symbol based envelope tracking. The method includes: determining a symbol based envelope tracking state based on transmit signal power; toggling an output bias voltage between a plurality of discrete voltage levels on symbol boundaries of a radio frequency signal based on the symbol based envelope tracking state, wherein the output bias voltage is provided to a power amplifier; adjusting digital predistortion based on the symbol based envelope tracking state, wherein a digital predistortion system that performs the digital predistortion is in a signal path that provides the radio frequency signal to the power amplifier; and amplifying the radio frequency signal with the power amplifier.

The method can include operating a power amplifier system that includes the power amplifier in a discontinuous transmit state.

The radio frequency signal can include two carriers having different symbol periods. Toggling the output bias voltage can occur on symbol boundaries of a carrier of the two carriers with a shorter symbol period.

Another aspect of this disclosure is a system with symbol based envelope tracking. The system includes a voltage modulator circuit and a signal path configured to provide a radio frequency signal. The voltage modulator circuit is configured to generate an output bias voltage based on a symbol based envelope tracking state such that the output bias voltage tracks a root mean square symbol power of the radio frequency signal on a symbol by symbol basis. The signal path includes a digital predistortion system configured to adjust digital predistortion based on the symbol based envelope tracking state.

The system can include a quantizer configured to determine the symbol based envelope tracking state based on an indication of transmit power. The system can include one or more delay blocks coupled between the quantizer and the digital predistortion system. The quantizer can receive a composite transmit symbol power associated with a plurality of carriers.

The signal path can include a crest factor reduction block configured to adjust a crest factor reduction threshold based on the symbol based envelope tracking state.

The voltage modulator circuit can transition the output bias voltage between discrete voltage levels of a plurality of discrete voltage levels in a time that is in a range between 5 nanoseconds and 200 nanoseconds.

For purposes of summarizing the disclosure, certain aspects, advantages and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

### BRIEF DESCRIPTION OF THE DRAWINGS

Embodiments of this disclosure will be described, by way of non-limiting example, with reference to the accompanying drawings.
Figure 1 is a bar graph of probability of cell resource usage for a relatively large number of base stations over a number of weeks.
Figure 2 is a graph of a radio frequency envelope of a 20 megahertz Long Term Evolution carrier over time with resource usage varying from 100% to 1.6%.
Figures 3A, 3B, and 3C are graphs for 5 symbols of a radio frequency signal.

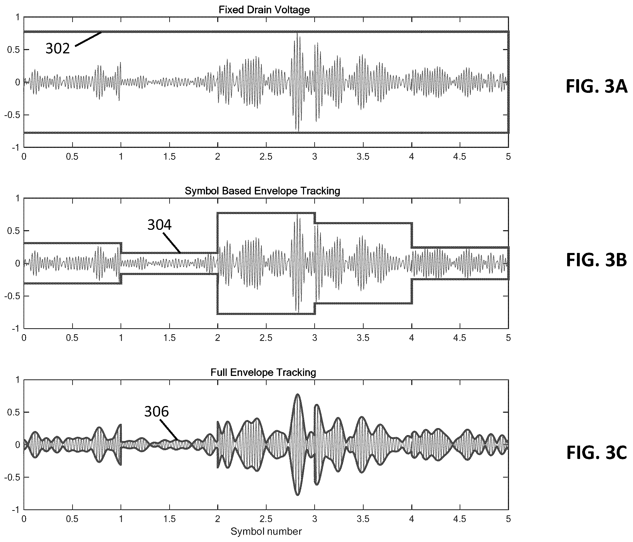

Figure 3A shows a fixed bias voltage. Figure 3B shows a symbol based envelope tracking bias voltage. Figure 3C shows a continuous envelope tracking voltage.

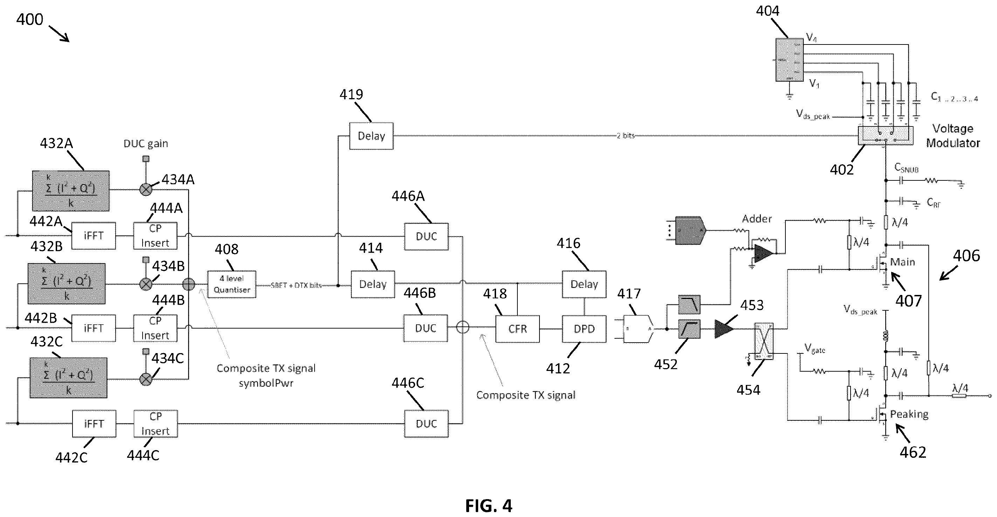

Figure 4 is a schematic block diagram of a symbol based enveloped tracking system according to an embodiment.

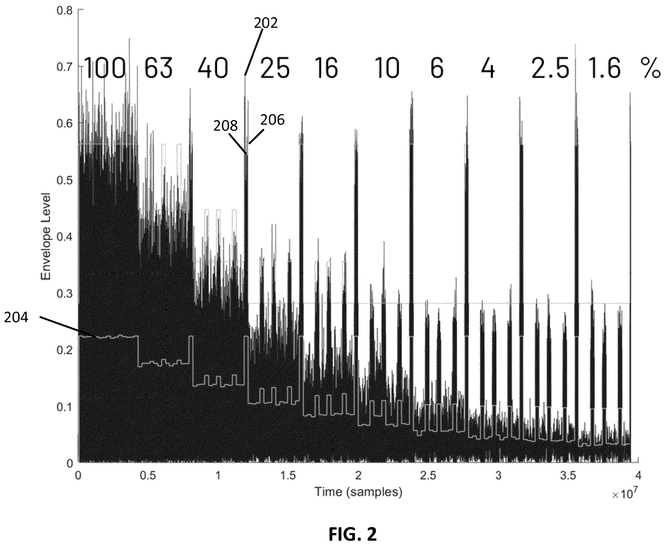

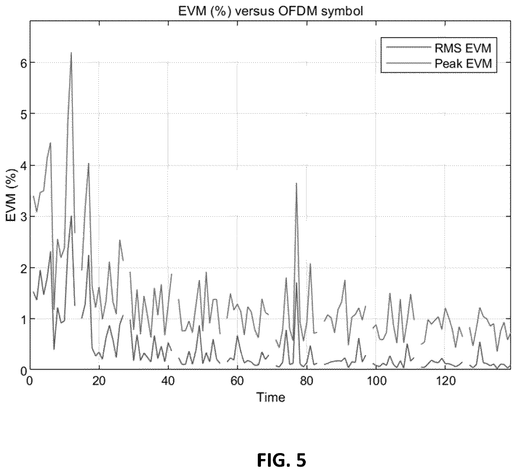

Figure 5 is a graph of error vector magnitude of each symbol for the 20 megahertz Long Term Evolution carrier corresponding to Figure 2.

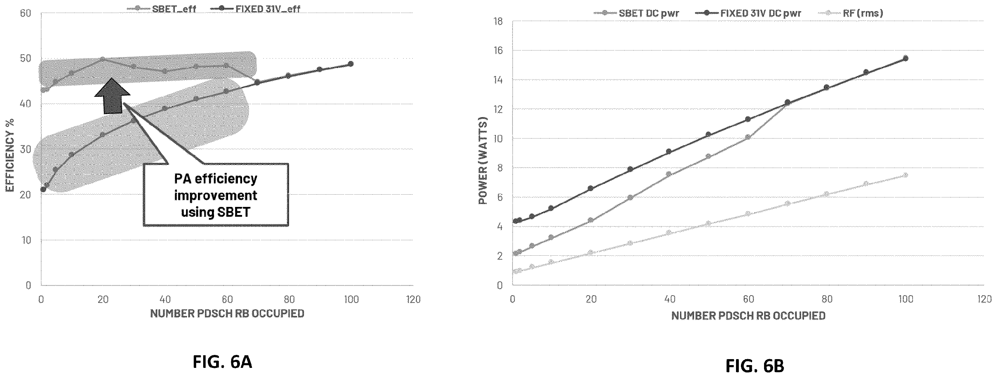

Figures 6A and 6B are graphs of experimental results showing efficiency and power savings using symbol based envelope tracking.

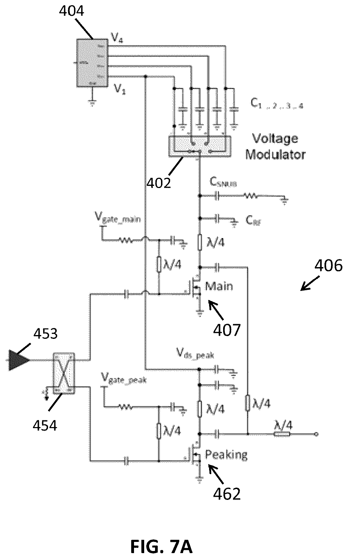

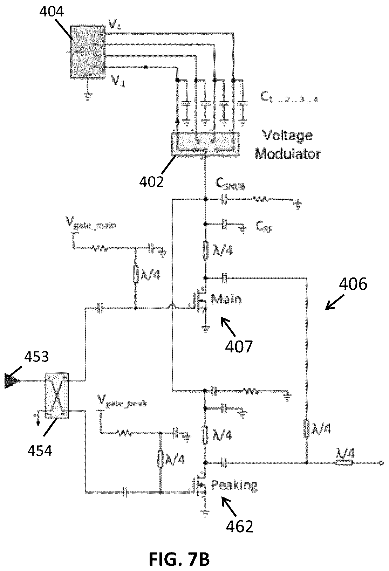

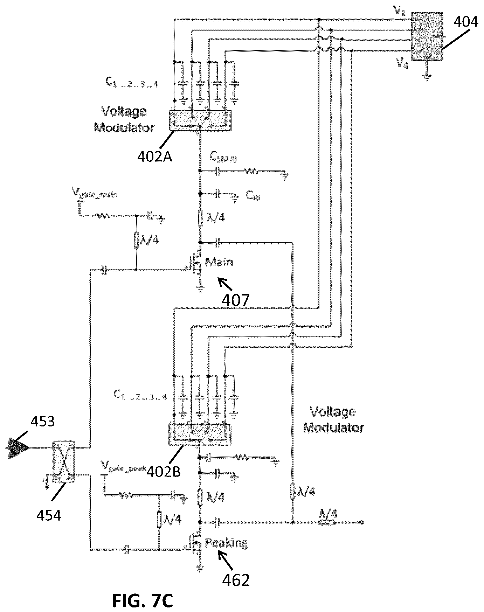

Figures 7A, 7B, and 7C are schematic diagrams of Doherty amplifiers connected to symbol based envelope tracking voltage modulators according to embodiments.

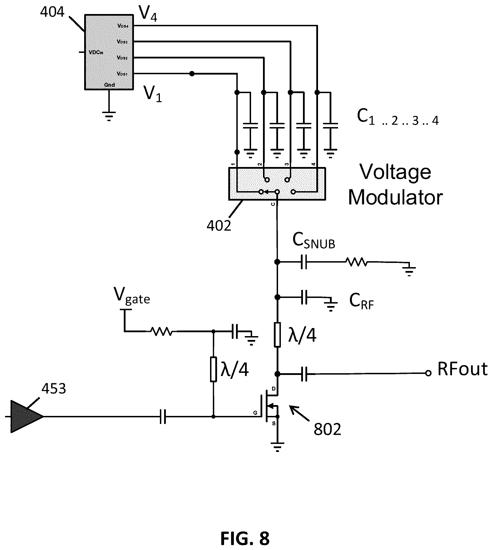

Figure 8 is a schematic diagram of a power amplifier transistor connected to a symbol based envelope tracking voltage modulators according to an embodiment.

### DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings. The headings provided herein are for convenience only and do not necessarily affect the scope or meaning of the claims.

### Introduction

Desirable features of cellular wireless base stations include maximising the data throughput capability, minimising energy consumption, minimising the purchase cost, minimising number of sites, and minimising size and weight.

It challenging to simultaneously achieve these desires. Over the last 20 years, it has been difficult to introduce energy saving measures where they produce a measurable impact on initial equipment cost (capital expenditure). Any increases in equipment cost have largely been in parallel with throughput enhancements. That situation has been gradually changing though, recent substantial increases in worldwide energy prices and the continual, gradual move to a greener economy is finally tipping the equation to favour a reduction in operating costs through energy consumption reduction even if it results in fractionally higher initial purchase costs.

The radio frequency (RF) power amplifier (PA) can be the dominant energy consumer in the wireless base station and despite evolutions, such as massive multiple-input multiple output (mMIMO), still remains so. Hence PAs can be a significant part of the base station design when it comes to energy reduction methods.

The cellular network is also becoming dominated by the newer wireless standards of fourth generation (4G) (Long Term Evolution) and fifth generation (5G) (New Radio) whilst phasing out the older technologies of third generation (3G) (Wideband Code Division Multiple Access) and second generation (2G) (Global System for Mobile communications). It looks as if 3G will phase out first with 2G remaining in a limited number of frequency bands on some continents, e.g. with Europe to support existing machine to machine (M2M) communications infrastructure. Either way, most of the new equipment installed going forward will be purely 4G and 5G using compatible orthogonal frequency-division multiplexing (OFDM) modulation schemes.

The operating modality of cellular wireless networks is to give the user a good experience. That generally means that if a user suddenly has a demand for network resources, then those network resources are immediately available. In the access network, those network resources include RF power and bandwidth. This generally means the wireless access network is operating with capacity to spare for the vast majority of time.

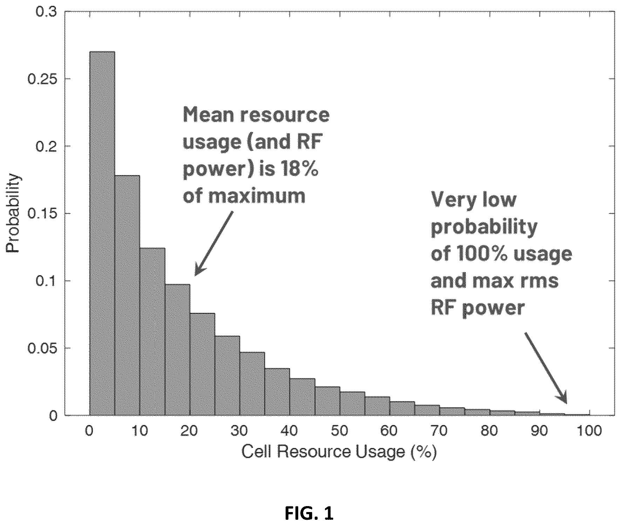

This can be seen in data taken from a large base station network over a period of weeks both day and night. Figure 1 is a bar graph of probability of cell resource usage taken of a large number of base stations over a number of weeks. In Figure 1, mean resource usage is 18% of maximum capacity. In Figure 1, cell resource usage can correspond to root mean square (RMS) RF output power. Figure 1 indicates a low probability of 100% resource using and maximum RMS RF power.

Even when taking into account low night-time usage, a base station is at high percentage utilisation for a relatively small amount of time. This gives an opportunity for energy savings by tailoring the efficiency of the RF PA at lower RF power output rather than at its maximum RF power.

Long Term Evolution (LTE) and New Radio (NR) both use OFDM modulation in the RF signal modulation. This means that LTE and NR are both symbol based transmission methods. Over the period of a symbol, approximately 70 µs for LTE and approx. 70/(2^N) µs for NR (where N is the numerology 0, 1, 2, ... 4), the RMS power of the waveform is a constant as it transmits what can be the sum of thousands of sine waves at different frequencies and relative phases. In the next symbol, there is likely a different sum of sine waves, which if there is not much data to transmit may just be a few sine waves. Within a symbol these sine waves add together to produce a peaky waveform with a peak/mean ratio around 11 decibels (dB), which can be clipped to around 8 dB by Crest Factor Reduction (CFR) with little loss of data integrity. This can be seen in Figure 2 for a 10 millisecond (ms) long LTE transmit waveform where the percentage usage of the available sinewaves varies from 100 to 1.6%.

Figure 2 is a graph of a radio frequency envelope of a 20 megahertz (MHz) LTE carrier over time with resource usage varying from 100% to 1.6%. The y-axis of this graph is the RF envelope (or amplitude). The x-axis of this graph is time in 491.52 MHz clock samples. The graph includes instantaneous amplitude (peaks) 202, a trace 204 at the RMS level, a trace 206 at the CFR clipping level, and a waveform envelope 208 after clipping at 8 dB peak-to-average power ratio (PAR).

Symbol Based Envelope Tracking (SBET) can exploit that the RF peak power involved in the lower power symbols to transmit these symbols is significantly reduced and can be supplied by the same RF transistor operating at a significantly reduced drain voltage. The reduced drain voltage can lead to significantly lower energy consumption. The drain voltage can be quickly switched from one value to another value in 10s of nanoseconds (ns) at the symbol boundary.

### Description of Certain Embodiments

Figures 3A, 3B, and 3C are graphs of drain voltage for 5 symbols of a radio frequency signal. Figure 3A shows a fixed bias voltage. Figure 3B shows a symbol based envelope tracking bias voltage. Figure 3C shows a continuous envelope tracking voltage. Figures 3A, 3B, and 3C graphically illustrate the concept of envelope tracking. The waveform is what a single RF PA transistor is aiming to produce on its output. The waveform is symbol based with symbol boundaries at 0, 1, 2, 3, 4, and 5 on the x axis, which corresponds to time. Hence the RMS power of the waveform changes on every symbol boundary (where symbols are typically 10s of microseconds long in LTE and NR).

If the system is limited to have a fixed drain voltage like in Figure 3A, that drain voltage supports the largest RF peak power it can produce. A fixed drain voltage line 302 is shown in Figure 3A. This the way most cellular wireless base station RF power amplifiers are configured. It is possible that slow changes (seconds or more) of the drain voltage can be achieved to accommodate when the likelihood of high traffic is minimal, such as at night time.

In Symbol Based Envelope Tracking (SBET), power amplifier transistor output terminal voltages (e.g., drain voltages) may only change on symbol boundaries as shown in the Figure 3B. The drain voltage can support the maximum peak power within that symbol. This improves PA efficiency as the same RF power is produced in the symbol but operating at a lower drain voltage shown as a symbol based envelope tracking line 304.

Figure 3C shows an even higher efficiency mode of operation using full envelope tracking. The drain voltage tracks every peak of the waveform envelope in Figure 3C. As shown in Figure 3C, a drain voltage curve 306 tracks each peak on the waveform envelope. However, this efficiency gain can come at the expense of having to change the drain voltage 1000s of times faster than for SBET. This full envelope tracking in Figure 3C is an order of magnitude more complex than SBET embodiments disclosed herein and involves sophisticated digital predistortion (DPD) and faster analog switches (e.g., gallium nitride (GaN) switches) than SBET. As the instantaneous bandwidth of the RF signal increases, full envelope tracking can find it difficult or impossible to track every peak and trough. In this case, a full envelope tracking can start skipping troughs to reduce complexity at the cost of losing some efficiency performance. This is different than disclosed embodiments of SBET, where the drain voltage only shifts value on the symbol boundaries. In SBET, the drain voltage can have a generally constant voltage level for an entire symbol while the waveform envelope has multiple peaks and troughs for the symbol.

In the case of NR (5G) mixed numerology carriers, the symbols lengths are shorter for the higher numerologies. In this case, SBET can switch at the symbol boundaries of the highest numerology carrier in some instances. Alternatively, SBET can switch at the symbol boundaries of the lowest numerology carrier in some other instances.

### SBET system architecture

Aspects of this disclosure relate to power amplifier systems with symbol based envelope tracking. A power amplifier system can include a voltage modulator circuit to generate an output bias voltage that tracks the RMS symbol power of a radio frequency signal changing on a symbol-by-symbol basis and a power amplifier configured to receive the output bias voltage and amplify the radio frequency signal. The power amplifier transmitter system can include a crest factor reduction circuit that adjusts a crest factor reduction threshold on symbol boundaries. The power amplifier transmitter system can include a DPD system that accounts for the output bias voltage in DPD.

A SBET state can be determined based on the RMS power of a transmit signal per symbol. The transmit signal can be a composite transmit signal that includes a plurality of carriers in certain application. The voltage modulator can adjust the output bias voltage based on the SBET state. The crest factor reduction circuit can adjust the crest factor reduction threshold based on the SBET state. The DPD system can adjust DPD based on the SBET state.

In applications where there is a composite transmit signal including two or more carriers with different symbol lengths, the SBET state can transition based on the shortest symbol length. In some other applications where there is a composite transmit signal including two or more carriers with different symbol lengths, the SBET state can transition based on the longest symbol length.

In response to detecting no power in the transmit signal, the power amplifier system can operate in a discontinuous transmit state. In the discontinuous transmit state, an output terminal of a power amplifier transistor (e.g., a drain of a field effect power amplifier transistor) can be connected to ground (short circuit) or at a floating potential (open circuit).

Figure 4 is a schematic block diagram of a SBET system 400 according to an embodiment. The SBET system 400 is a power amplifier system that includes a power amplifier. As illustrated, the SBET system 400 includes a voltage modulator 402, a supply voltage circuit 404, and a power amplifier 406. The SBET system 400 has 4 SBET voltages that can be selected for a drain of a power amplifier transistor and the waveform is made up from 3 individual carriers. Any other suitable number of SBET voltages and/or any other suitable number of individual carriers can be used in some other applications.

The voltage modulator 402 selects 1 from N fixed voltages from the supply voltage circuit 404 to provide the power amplifier 406. In the illustrated power amplifier 406, the selected voltage is provided to a drain of a power amplifier transistor 407. Each of the voltages from the supply voltage circuit 404 corresponds to an SBET state 1 to N. There can be any suitable number of SBET states for a particular application. For example, in certain applications there are 2 SBET states, 4 SBET states as illustrated in Figure 4, 8 SBET states, or 16 SBET states. The voltage modulator 402 can generate an output bias voltage that tracks an envelope of an RF signal on a symbol-by-symbol basis. The output bias voltage can track the envelope of the radio frequency signal for a group of symbols and/or for each individual symbol. The output bias voltage can have a transition time of 10s of nanoseconds. In certain applications, the voltage modulator 402 can transition the output bias voltage between discrete voltage levels in a time that is in a range between 5 nanoseconds and 200 nanoseconds. In some applications, the voltage modulator 402 can transition the output bias voltage between discrete voltage levels in a time that is in a range between 5 nanoseconds and 50 nanoseconds. The output bias voltage can be stepped significantly (e.g., from 25 Volts (V) to 50 V) on a symbol boundary.

The SBET system 400 also has a state, which is called discontinuous transmit (DTX) mode, where there is no RF power to transmit in a symbol. In this case, either no voltage is connected to common side of the switches (open circuit) or the drain of the power amplifier transistor 407 is connected via a switch to ground. The PA output bias voltage can be discharged so it approaches zero volts (e.g., ground) in the DTX state. In the DTX state, the RF PA 406 is off and should draw negligible power.

The voltage modulator 402 can provide a constant voltage for an entire symbol and switch state on symbol boundaries. The voltage modulator 402 can select from a plurality of discrete voltages (e.g., V1, V2, V3, V4) to provide as the output bias voltage based on SBET state. The voltage modulator 402 can toggle the output bias voltage among these discrete voltages on symbol boundaries. In some applications, the voltage modulator 402 can provide a constant voltage for a group of symbols and change state on symbol boundaries.

In certain applications, the voltage modulator 402 can only switch state on the symbol boundaries of the carrier with the shortest symbol period (highest numerology in NR) when a composite transmit signal includes carriers with different symbol lengths. For instance, in the SBET system 400, if one carrier has a symbol length that is half of the symbol length of the other two carriers, then a quantizer 408 can determine a SBET state at or near symbol boundaries of the symbols having half of the length of the other symbols. The RMS power of the symbols for the other two carriers can hold the same value for two different symbols of the shorter symbol length in this example.

In some applications, the voltage modulator 402 can only switch state on the symbol boundaries of a carrier with the longest symbol period (lowest numerology in NR) when a composite transmit signal includes carriers with different symbol lengths. For instance, in the SBET system 400, if a first carrier has a longer symbol length than the second and third carriers, then a quantizer 408 can determine a SBET state at or near symbol boundaries of the symbols of the first carrier of the composite signal. The maximum RMS power of each individual symbol of the second carrier corresponding to one symbol of the first carrier can be used in determining the SBET state. Similarly, the maximum RMS power of each individual symbol of the third carrier corresponding to one symbol of the first carrier can be used in determining the SBET state. The SBET state can thus be determined and set for the peak RMS power of the composite symbol for the length of the longest length symbol in this example.

The capacitors C_{RF} and C_{SNUB} can be relatively small (e.g., having a capacitance of less than 1 nanofarad) to reduce and/or minimise the switching/settling time of the drain voltage of the power amplifier transistor 407. The capacitors Ci to C_{N} (C₁ to C₄ in Figure 4) can be larger (e.g., microfarad sized) decoupling capacitors.

The fixed voltages Vi to V_{N} provided by the supply voltage circuit 404 can be chosen such that the highest voltage Vi supports the highest peak RF power (typically Ppk(max) = Prms(max) + 8 dB approximately) after applying crest factor reduction (CFR). The lowest voltage V_{N} (i.e., V₄ in Figure 4) can be limited by the gain reduction caused by lower drain voltage. The lowest voltage V_{N} can depend on the PA transistor technology. In certain instances, V_{N} ≈ ½ Vi with an approximate 6 dB gain reduction. With too much gain reduction, the benefit of SBET can start to reduce. Each SBET state can have an associated and different CFR threshold level such that each SBET state supports a different RF peak power. In some applications, a subset of SBET states can have different CFR threshold levels to support different RF peak powers.

The intermediate drain voltage levels (e.g., V₂ and V₃ in Figure 4) can span between the largest and smallest voltages. There is a trade off in choosing the number of discrete voltages, with more discrete voltages generally corresponding to higher efficiency improvement but at the expense of increased cost and board area. A typical range of values for N is from 2 to 4 in certain applications. The voltage modulator 402 can implement the DTX state. In the DTX state, all switches of the voltage modulator 402 can be off or one or more switches can be connected to ground.

The SBET system 400 can include a digital predistortion (DPD) block 412 to compensate for non-linearity of the power amplifier 406. The DPD block 412 is a DPD system. The DPD block 412 can include a DPD actuator and a DPD adaptation circuit. For the power amplifier 406, the RF PA non-linearity response can be a function of drain voltage. Accordingly, the DPD performed nu the DPD block 412 can also be a function of SBET state. In the SBET system 400, SBET state feeds into the DPD block 412 after a matching delay. As shown in Figure 4, the quantizer 408 can output a SBET state and delay blocks 414 and 416 can add the matching delay so that the SBET state received by the DPD block 412 corresponds to the input signal to the DPD block 412.

DPD can be adjusted based on the DPD SBET state. Adjusting DPD can involve adjusting DPD coefficients and/or adjusting a DPD actuator. In certain implementations, the DPD model coefficients can be switched on the symbol boundary. Alternatively or additionally, a DPD actuator can be adjusted by enabling and/or disabling certain functionality and/or by adjusting topology of the DPD actuator. This can adjust a DPD model to correspond to an SBET state. The model can be adjusted, for example, by adjusting connections of signal paths in a DPD actuator that include non-linear gain blocks (e.g., lookup tables) and/or by adjusting connections of an artificial neural network in a DPD actuator. Each SBET state or output bias voltage level can have its own DPD model/coefficients, which can switch simultaneously in one clock cycle as the symbol data boundary passes through the DPD block 412.

To simplify the DPD implementation, no effort may be made to accurately correct for PA distortion during the switchover transition when the drain voltage is between the two set voltages. However, the switchover duration can be minimised to 10s of nanoseconds to minimise spectral distortion contribution of switchover on average. The distortion may be relatively high in the transition time but on average it can be reduced by approximately 1: 1000, which is the approximate ratio of the voltage transition time to the symbol period. An output of the DPD block 412 can be provided to a digital-to-analog converter (DAC) 417 to generate an analog transmit signal.

The analog signal from generated by the DAC 417 can be filtered by a filter 452, amplified by amplifier 453, and split by a hybrid splitter 454. The hybrid splitter 454 can provide an RF signal to a main power amplifier transistor 407 and a peaking power amplifier transistor 462 of the power amplifier 406. The hybrid splitter 454 can also provide a phase shift such that there is a 90 degree phase shift between the output signals provided by the hybrid splitter 454. The power amplifier 406 of the SBET system 400 is a Doherty power amplifier as illustrated.

Error Vector Magnitude (EVM) impact due to the drain voltage transitions can be less of a concern as the transition occurs during the cyclic prefix period for most symbols. Though it can occur within a symbol in the case of mixed numerology.

The CFR threshold used to limit the peak power of the digital signal can be a function of the SBET state. In the SBET system 400, the SBET state feeds into a CFR block 418 after a matching delay. As shown in Figure 4, the quantizer 408 can output the SBET state and a delay block 414 can add the matching delay so that the SBET state received by the CFR block 418 corresponds to the input signal to the CFR block 418. The CFR block 418 can adjust the CFR threshold based on the SBET state. Accordingly, the CFR threshold can correspond to the output bias voltage provided to the power amplifier 406. The CFR block 418 can be implemented by any suitable circuitry. Digital circuitry of a digital signal processor can implement the CFR block 418. A transceiver integrated circuit can implement the CFR block 418, for example.

Adjusting a CFR threshold based on SBET state can be significant to the energy saving performance of SBET system 400. By having a different CFR threshold for each SBET state (e.g., drain voltage), the peak RF power is defined for each SBET level. The lower the CFR threshold, the greater the energy saving but the higher the signal distortion and EVM, which in turn should raise the Bit Error Rate (BER). A compromise is to ensure that the PAR of any symbol in any SBET state remains greater than or equal to a threshold value. An example threshold value is 8 dB.

Figure 5 is a graph of EVM of each symbol for the 20 MHz LTE carrier corresponding to Figure 2. The EVM for each of the 140 symbols in the waveform of Figure 2 is shown in Figure 5. The RMS EVM of the reduced power symbols is below 1% except for 1 symbol where the CFR clips the most peaks.

Referring to Figure 4, the SBET state is carried by the SBET+DTX bits which are output from the n level quantizer 408. The n level quantizer 408 is a 4 level quantizer in Figure 4 because there are 4 SBET voltages provided by the voltage modulator circuit 402. The SBET+DTX bits can change state on each symbol boundary. The bits are delayed appropriately so that these bits arrive at the CFR block 418, the DPD block 412, and the voltage modulator 402 and change to their configuration for the new SBET state as the transmit data passes through the SBET system 400 (in the case of the voltage modulator 402 it is the analog signal passing through the field effect transistors of the power amplifier 406). The delay blocks 414, 416, and 419 provide such delays for the SBET state bits.

The appropriate SBET state can be determined by effectively calculating the composite transmit RMS signal power of each complete symbol at an input to the CFR block 418. The quantizer 408 can determine the composite transmit RMS signal power. The composite transmit signal can be formed from a plurality of carriers. In the SBET system 400, each carrier can be received as a frequency domain signal; transformed to the time domain by a respective inverse Fast Fourier Transform (iFFT) block 442A, 442B, 442C; a cyclic prefix (CP) can be added by a respective CP block 444A, 444B, 444C, and upconverted by a respective digital upconverter (DUC) 446A, 446B, 446C. Outputs of the DUCs 446A, 446B, 446C can be combined to form the composite transmit signal provided to the CFR block 418.

However, calculating transmit power directly at the input of the CFR block 418 may not be ideal as it can take many microseconds at least (and ideally the whole symbol) to get an accurate result. Such a calculation can be ready too late as the composite transmit RMS signal symbol power should be known at the start of the symbol not the end. While 10s of microseconds of delay can be added to the transmit signal path to compute transmit power at the input of the CFR block 418, such a delay is generally not desirable.

Another approach is to calculate the symbol power of each carrier multiplied by the individual carrier dependent gain from an iFFT input to a CFR input, then sum the individual carrier powers together. In the SBET system 400, the iFFT gain blocks 432A, 432B, and 432C and multipliers 434A, 434B, and 434C can create a composite transmit signal symbolPwr at the input to the n level quantizer 408 that has a power corresponding to the composite transmit signal at an input of the CFR block 418. The iFFT gain blocks 432A, 432B, and 432C can provide gains corresponding to the iFFT blocks 442A, 442B, and 442C. The gain applied to in each multiplier 434A, 434B, and 434C can correspond to a gain of a corresponding DUC of the DUCs 446A, 446B, and 446C that form the composite transmit signal that is input to the CFR block 418. Processing the frequency domain data rather than time domain data means the symbol power information can be available before the symbol boundary of the compositive transmit signal is provided to the input of the CFR block 418.

The quantizer 408 can determine an SBET state based on the composite transmit signal symbolPwr it receives. The N level quantizer 408 can be preprogramed with N thresholds in a thermometer fashion and output the SBET state as a number from 1 to N. The DTX bit is a special condition when the symbol power is zero (or near zero) and can be used disable all switches, so the common switch node of the voltage modulator 402 is open circuit or using an additional switch short the drain of the power transistor407 to ground.

### SBET performance

An aim of adding SBET is to reduce the energy consumption of the RF PAs, which should reduce operating expenses, in wireless base stations. With this reduced energy consumption, performance of the RF PA can be degraded minimally in terms of transmitted signal purity (e.g., EVM) and spectral emissions. It is also desirable to achieve these objectives with minimal increase in equipment cost (capital expenditures).

Figures 6A and 6B are graphs of experimental results showing efficiency and power savings using SBET. Figure 6A shows the drain efficiency enhancement using SBET with an off-the-shelf GaN Doherty PA Module aimed at small cells and massive MIMO base stations. SBET is compared to using a 31 V fixed voltage supply for these PAs. A number of transmit waveforms were generated for a single 20 MHz LTE carrier. The different waveforms were generated so that the number of resource blocks (RB) occupied for data (Physical Downlink Shared Channel (PDSCH)) varied from 1 to 100 RBs. The other physical channels (RS, Physical Broadcast Channel (PBCH), and Physical Control Format Indicator Channel (PCFICH), and Physical Downlink Control Channel (PDCCH)) were the same for all waveforms. This approximately mimics different cell resource usage from 1% to 100% as a 20 MHz LTE carrier has a maximum of 100 RBs.

For SBET in Figures 6A and 6B, there were 4 voltages used with the largest being 31 V and the lowest being 15.5 V. The transition time for drain voltage from one symbol to the next symbol was ~20 nanoseconds.

In Figure 6B, the RMS RF output power (averaged over all symbols of a 1 ms frame) varied from 0.9 Watts (W) at 1 RB to 7.5 W at 100 RB, where at 1 RB most of the power is consumed by the non-data physical channels in the waveform. As the number of data RBs reduces from 100%, RF output power reduces proportionately and initially there is no power saving using SBET until around 60% when the drain voltage has its first drop to a lower voltage. From this point on, SBET provides a significant saving in the direct current (DC) power from the drain supplies.

In Figure 6A, SBET maintains the PA drain efficiency in the 45%-50% range over a relatively wide range of RF output powers. The efficiency improvement is largest at the lower powers, but here there is less power to be saved. Figure 6B shows that ~2 W of DC power is saved from around 1% to 60% RB utilization with no power savings above about 70% RB utilization. These efficiency figures include the power loss in the modulator, which is relatively small. The modulator is ~99% efficient as a frequency of switch changes is relatively low (low 10s of kHz) and switch losses are mainly from on resistance (Rds) of the switch, which is also relatively low.

The efficiency enhancements of SBET above turn into energy savings at the base station dependent upon the fraction of time the base station spends at a certain percentage resource usage. If the base station is always at 100% usage, there may be no savings from SBET. If base station usage is always at 1%, the savings can be huge.

The statistics of base station resource usage in Figure 1 allow us to estimate power saving over an ensemble of base stations in a network averaged over day/night and the week. High resource usage only happens for a small fraction of the time. If we assume a 64 transmit 64 receive (64T64R) massive MIMO base station capable of producing 320 W of RMS power (maximum), that will use about 64 of the PAs corresponding to Figure 6A. The average 320 W capable base station in that network would consume about 9 kWh/day of energy in the output stage of its RF PAs, whereas if SBET was used it would only consume about 6.2 kWh/day of energy. This is a significant energy savings.

### Other Features

Additional features of SBET systems will be discussed. Any suitable principles and advantages of these feature can be implemented together with each other and/or any of the embodiments disclosed herein.

### Tristate logic to save number of logic lines to modulator

In Figure 4, the number of logic lines to drive the voltage modulator 402 is ceiling(log2(n)), where n is the number of voltages (or SBET states). Adding the DTX state could add an extra logic line. Therefore, implementing the DTX state as tri-stating the SBET logic lines can save the need for an extra logic line. A tri-state driver can have a third state where it is floating or open circuit for the DTX state. A tri-state driver can be implemented in a SBET system with the DTX state.

### Crest Factor Reduction

A typical CFR block can have 3 consecutive engines that first detect peaks and then correct peaks. During detection, the CFR block 418 can record the SBET/threshold level with the peak. The threshold can then be passed to the correction hardware. The correction hardware can reduce the peaks to the desired level. There can be a central block that delays the update to each engine so that the threshold changes at the same relative sample for each engine. This can be expanded to non-SBET uses as well, we can now align threshold and the pulse updates to symbol boundaries. Updates can be seamless with these features, where previously one engine was disabled at a time to update thresholds. Such features can be implemented in the CFR block 418 of Figure 4.

### Digital Predistortion

DPD can measure and then correct a non-linear response of the RF power amplifier. As noted above, the RF PA non-linearity response can be a function of drain voltage. Therefore, a non-linear compensation block in DPD can be a function of SBET state, which means non-linear coefficients/models can change with SBET state and drain voltage at symbol boundaries. An additional complication of using certain transistors (e.g., GaN RF transistors) in an RF PA is its charge trapping behavior can alter the PA non-linear characteristics on a long-term timescale of microseconds to milliseconds. Neural Predistortion (NPD) can be implemented for long term tracking of the RF PA nonlinearity. Using SBET can amplify the long term dynamic nonlinear behavior compared to a fixed drain voltage, which can be particularly apparent in GaN RF power transistors.

Within the NPD input data path, the PA drain voltage (SBET Level) can be tracked. Each of the N SBET levels (e.g., 4 SBET levels of the SBET system 400 of Figure 4) can be expanded into a binary level, so there are N binary levels that are passed to a Neural Network (NN). Certain NNs use 8-bits MACs. For such NNs, there can be 8-bit programmable values to indicate 0 or 1. This allows the NN to learn the optimal 8-bit values for all the levels. Such features can be implemented in the DPD block 412 of Figure 4.

### Radio Frequency Power Amplifier Connections

The Doherty RF amplifier can be used in wireless infrastructure base stations at RF frequencies below 7 gigahertz (GHz). There are a number of connection options for an SBET voltage modulator to the 2 (or more) transistors of an RF Doherty amplifier. Figures 7A, 7B, and 7C are schematic diagrams of Doherty power amplifiers 406 connected to SBET voltage modulators 402 according to embodiments. These Doherty power amplifiers 406 include a main power amplifier transistor 407 and a peaking power amplifier transistor 462.

In Figure 7A, one voltage modulator 402 is used connected to the main power amplifier transistor 407 while the peaking power amplifier transistor 462 has a fixed supply voltage. In Figure 7B, the drain of main power amplifier transistor 407 and the peaking power amplifier transistor 462 are connected to the same voltage modulator 402 at a common node or common switch point. It can be desirable to reduce and/or minimize the physical distance between the output node of the voltage modulator 402 and the power amplifier transistor drains in physical layout. In Figure 7C, there are 2 voltage modulators 402A and 402B, one voltage modulator 402A connected to the drain of the main power amplifier transistor 407 the other voltage modulator 402B connected to the drain of the peaking power amplifier transistor 462.

There are tradeoffs in price/performance between the 3 configurations shown in Figures 7A, 7B, and 7C. Each of the 3 configurations is advantageous in particular applications.

Using a Doherty amplifier with SBET has benefits to the efficiency at maximum RMS power output as well as at lower RMS output power.

SBET can also enhance the efficiency of non-Doherty RF amplifier stages whether used standalone or in other configurations such as a Load Modulated Balanced Amplifier (LMBA). Figure 8 illustrates an example of voltage modulator 402 with SBET connected to a single power amplifier transistor 802.

### Power Amplifier Transistors

Although embodiments disclosed herein may be discussed with reference to power amplifier field effect transistors and modulating a drain voltage for symbol based envelope tracking, any suitable principles and advantages disclosed herein can be implemented with power amplifiers having a different type of power amplifier transistor output stage. In some applications, a power amplifier in a symbol based envelope tracking system in accordance with any suitable principles and advantages disclosed herein can include without limitation field effect transistors, complementary metal oxide semiconductor (CMOS) transistors, a bipolar transistor, a heterojunction bipolar transistor, or the like. Where a power amplifier includes a bipolar power amplifier transistor, symbol based envelope tracking can modulate a bias voltage at a collector of the bipolar power amplifier transistor and/or any other suitable teachings applied to a drain can be applied to a collector. A power amplifier transistor can be implemented by any suitable transistor technology for a particular application. Example power amplifier transistors can include, but are not limited to, GaN transistors, silicon transistors, silicon-on-insulator transistors, SiGe transistors, GaAs transistors, SiC transistors, InP transistors, or the like. Moreover, any of the power amplifier transistors disclosed herein can be implemented by two or more power amplifier transistors.

### Wireless Communication Standards

Although embodiment disclosed herein may be discussed with reference to certain communications standards, any suitable principles and advantages disclosed herein can be implemented with radio frequency systems that transmit a radio frequency signal via one or more antennas according to any suitable wireless communication standard. In some applications, a radio frequency system with symbol based envelope tracking in accordance with any suitable principles and advantages disclosed herein can generate signal according to any suitable wireless communication standard, such as a Wi-Fi standard, another local wireless area network standard, a personal wireless area network standard, a future cellular technology standard, or the like.

### Conclusion

In the embodiments described above, apparatus, systems, and methods for power amplifier envelope trackers are described in connection with particular embodiments. It will be understood, however, that the principles and advantages of the embodiments can be used for any other systems, apparatus, or methods with a need for envelope tracking.

The principles and advantages described herein can be implemented in various apparatuses. Examples of such apparatuses can include, but are not limited to, communications infrastructure such as wireless or wired communications infrastructure, consumer electronic products, parts of the consumer electronic products, electronic test equipment, vehicular electronic products, industrial electronic products, etc. Electronic products can include, but are not limited to, base stations such as cellular base stations, access points, repeaters, relays, wireless communication devices, a mobile phone (for example, a smart phone), a hand-held computer, a tablet computer, a laptop computer, a wearable computing device, a vehicular electronics system, a radio, a wearable health monitoring device, an Internet of Things (IoT) device, etc. Further, apparatuses can include unfinished products.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all the following interpretations of the word: any of the items in the list, all the items in the list, and any combination of the items in the list. All numerical values provided herein are intended to include similar values within a measurement error.

Moreover, conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states.

The teachings of the inventions provided herein can be applied to other systems, not necessarily the systems described above. The elements and acts of the various embodiments described above can be combined to provide further embodiments. The acts of the methods discussed herein can be performed in any order as appropriate. Moreover, the acts of the methods discussed herein can be performed serially or in parallel, as appropriate.

While certain embodiments of the inventions have been described, these embodiments have been presented by way of example only and are not intended to limit the scope of the disclosure. Indeed, the novel methods and systems described herein may be embodied in a variety of other forms. Furthermore, various omissions, substitutions, and changes in the form of the methods and systems described herein may be made without departing from the spirit of the disclosure. For example, while the disclosed embodiments are presented in given arrangements, alternative embodiments may perform similar functionalities with different components and/or circuit topologies, and some elements may be deleted, moved, added, subdivided, combined, and/or modified. Each of these elements may be implemented in a variety of different ways as suitable. Any suitable combination of the elements and acts of the various embodiments described above can be combined to provide further embodiments. The accompanying claims and their equivalents are intended to cover such forms or modifications as would fall within the scope and spirit of the disclosure. Accordingly, the scope of the present inventions is defined by reference to the claims.

## Claims

1. A power amplifier system with symbol based envelope tracking, the power amplifier system comprising:
a voltage modulator circuit configured to generate an output bias voltage that tracks a root mean square symbol power of a radio frequency signal, the voltage modulator circuit configured to adjust the output bias voltage on symbol boundaries;
a power amplifier configured to receive the output bias voltage and amplify the radio frequency signal; and
a signal path configured to provide the radio frequency signal to the power amplifier, the signal path comprising a crest factor reduction block configured to adjust a crest factor reduction threshold such that the crest factor reduction threshold corresponds to the output bias voltage.

2. The power amplifier system of Claim 1, further comprising a quantizer configured to determine a symbol based envelope tracking state based on transmit signal power, wherein the voltage modulator circuit is configured to generate the output bias voltage based on the symbol based envelope tracking state, and the crest factor reduction block is configured to adjust the crest factor reduction threshold based on the symbol based envelope tracking state.

3. The power amplifier system of Claim 2, wherein the signal path comprises a digital predistortion system coupled between the crest factor reduction block and a digital-to-analog converter, wherein the digital predistortion system is configured to adjust digital predistortion based on the symbol based envelope tracking state.

4. The power amplifier system of Claim 2 or claim 3, wherein the quantizer is configured to receive a composite transmit symbol power associated with a plurality of carriers.

5. The power amplifier system of any preceding Claim, wherein the signal path comprises a digital-to-analog converter coupled between an output of the crest factor reduction block and an input to the power amplifier.

6. The power amplifier system of any preceding Claim, wherein the power amplifier system is operable in a discontinuous transmit state.

7. The power amplifier system of Claim 6, wherein a power amplifier transistor of the power amplifier system has an output terminal connected to ground in the discontinuous transmit state.

8. The power amplifier system of Claim 6, wherein a power amplifier transistor of the power amplifier system has an output terminal that is floating in the discontinuous transmit state.

9. The power amplifier system of any preceding Claim, wherein the radio frequency signal comprises at least two carriers with different symbol lengths, and the voltage modulator circuit is configured to adjust the output bias voltage corresponding to symbol boundaries of a carrier of the at least two carriers with a shortest symbol period.

10. The power amplifier system of any preceding Claim, wherein the power amplifier comprises a main power amplifier transistor coupled to the voltage modulator circuit and a peaking power amplifier transistor coupled to any one of:
(a) a fixed voltage supply;
(b) the voltage modulator circuit;
(c) a second voltage modulator circuit.

11. The power amplifier system of any preceding Claim, wherein at least one of the following applies:
(a) the voltage modulator circuit is configured to transition the output bias voltage between discrete voltage levels in a time that is in a range between 5 nanoseconds and 200 nanoseconds;
(b) the voltage modulator circuit is configured to transition the output bias voltage between discrete voltage levels of at least 4 discrete voltage levels on the symbol boundaries.

12. A base station comprising the power amplifier system of any preceding Claim.

13. A method of radio frequency signal amplification with symbol based envelope tracking, the method comprising:
determining a symbol based envelope tracking state based on transmit signal power;
toggling an output bias voltage between a plurality of discrete voltage levels on symbol boundaries of a radio frequency signal based on the symbol based envelope tracking state, wherein the output bias voltage is provided to a power amplifier;
adjusting a crest factor reduction threshold of a crest factor reduction block based on the symbol based envelope tracking state, the crest factor reduction block being in a signal path that provides the radio frequency signal to the power amplifier; and
amplifying the radio frequency signal with the power amplifier.

14. The method of Claim13, wherein at least one of the following applies:
(a) the method further comprises adjusting digital predistortion in the signal path based on the symbol based envelope tracking state;
(b) the method further comprises operating a power amplifier system that includes the power amplifier in a discontinuous transmit state;
(c) the radio frequency signal comprises two carriers having different symbol periods, and the toggling occurs on symbol boundaries of a carrier of the two carriers with a shorter symbol period.

15. A system with symbol based envelope tracking, the system comprising:
means for generating an output bias voltage that tracks a root mean square symbol power of a radio frequency signal on a symbol-by-symbol basis; and
a signal path configured to provide the radio frequency signal, the signal path comprising a crest factor reduction block configured to adjust a crest factor reduction threshold such that the crest factor reduction threshold corresponds to the output bias voltage.
